# EUROPEAN PATENT APPLICATION

(11) **EP 4 838 301 A1**
(43) Date of publication of application: **11.11.2026**
(21) Application number: 26169428.5
(22) Date of filing: 31.03.2026
(51) Int. Cl.: G03F 1/62, B82Y 30/00, B82Y 40/00, C23C 14/02, C23C 14/20, C23C 14/58

(54) **A PLANARIZED STRUCTURE**

(30) Priority: 15.04.2025 FI 20255343
(71) Applicant: Canatu Finland Oy, 01720 Vantaa (FI)
(72) Inventor: CHIAPPE, Daniele, 01720 Vantaa (FI); SOLIMAN, Ahmed, 01720 Vantaa (FI)
(74) Representative: Papula Oy

(57) **Abstract**

A method for producing a planarized structure comprising a metal-containing or metalloid-containing coating layer between a first and a second film of carbon nanostructures is disclosed. The method comprises: - providing a first film of carbon nanostructures, -forming a polymer-based material on the first film of carbon nanostructures by a solution-based deposition technique to form a planarization layer on the first film of carbon nanostructures, -forming a metal-containing or metalloid-containing material on the planarization layer by a vapor phase deposition technique to form a planarized metal-containing or metalloid-containing coating layer on the planarization layer, -providing a second film of carbon nanostructures on the planarized metal-containing or metalloid-containing coating layer to form a pre-structure, - subjecting the formed pre-structure to a densification treatment; and removing the planarization layer from the pre-structure by a dissolution technique to produce the planarized structure. Further is disclosed the use of the planarized structure obtainable by the method.

## Description

### TECHNICAL FIELD

The present disclosure relates to a method for producing a planarized structure consisting of a metal-containing or metalloid-containing coating layer between a first and a second film of carbon nanostructures. The present disclosure further relates to the use of the planarized structure.

### BACKGROUND

Extreme ultraviolet lithography (EUV or EUVL) is an optical lithography technology using a range of extreme ultraviolet wavelengths. EUV pellicle films are used to protect a photomask from defects, enhance precision, shorten processing, and increase production efficiency on a wafer. However, defects in printing remain a key constraint to EUV lithography uptake. Further, optical filters are components designed to selectively transmit or block specific wavelengths of light. These filters play a role in applications such as spectroscopy, telecommunications, biomedical imaging, and photography. The material and coating technologies used determine their performance, including spectral range, durability, and thermal resistance. Despite their advantages, the performance of optical filters can be constrained by challenges such as durability under high-power laser applications, thermal degradation, and manufacturing tolerances. Issues such as surface defects, coating inconsistencies, or environmental factors like humidity can introduce scattering or absorption losses, reducing filter efficiency and lifespan. Thus, sophisticated particle filters like the EUV pellicles or optical filters are needed.

### SUMMARY

A method for producing a planarized structure consisting of a metal-containing or metalloid-containing coating layer between a first and a second film of carbon nanostructures is disclosed. The method comprises:
- providing a first film of carbon nanostructures,
- forming a polymer-based material on the first film of carbon nanostructures by a solution-based deposition technique to form a planarization layer on the first film of carbon nanostructures,
- forming a metal-containing or metalloid-containing material on the planarization layer by a vapor phase deposition technique to form a planarized metal-containing or metalloid-containing coating layer on the planarization layer,
- providing a second film of carbon nanostructures on the planarized metal-containing or metalloid-containing coating layer to form a pre-structure,
- subjecting the formed pre-structure to a densification treatment; and
- removing the planarization layer from the pre-structure by a dissolution technique to produce the planarized structure.

Further is disclosed the use of the planarized structure obtainable by the method as disclosed in the current specification as an optical filter, an optical mirror, a debris filter, a pellicle, a membrane filter, an electron blocking window, an X-ray window, an X-ray optical filter and an X-ray optical filter mirror, or any combination of at least two of these.

### BRIEF DESCRIPTION OF THE DRAWINGS

The accompanying drawings, which are included to provide a further understanding of the embodiments and constitute a part of this specification, illustrate embodiments and together with the description help to explain the principles of the invention. In the drawings:
Fig. 1 presents one embodiment for producing the planarized structure.
Fig. 2 presents the results from example 2.

### DETAILED DESCRIPTION

The present disclosure relates to a method for producing a planarized structure consisting of a metal-containing or metalloid-containing coating layer between a first and a second film of carbon nanostructures, wherein the method comprises:
- providing a first film of carbon nanostructures,
- forming a polymer-based material on the first film of carbon nanostructures by a solution-based deposition technique to form a planarization layer on the first film of carbon nanostructures,
- forming a metal-containing or metalloid-containing material on the planarization layer by a vapor phase deposition technique to form a planarized metal-containing or metalloid-containing coating layer on the planarization layer,
- providing a second film of carbon nanostructures on the planarized metal-containing or metalloid-containing coating layer to form a pre-structure,
- subjecting the formed pre-structure to a densification treatment; and
- removing the planarization layer from the pre-structure by a dissolution technique to produce the planarized structure.

The present disclosure further relates to the use of the planarized structure obtainable by the method as disclosed in the current specification as an optical filter, an optical mirror, a debris filter, a pellicle, a membrane filter, an electron blocking window, an X-ray window, an X-ray optical filter and an X-ray optical filter mirror or any combination of at least two of these.

In one embodiment, the planarized structure is used as an extreme ultraviolet lithography pellicle.

In one embodiment, the planarized structure consists of a metal-containing or metalloid-containing coating layer between a first and a second film of carbon nanostructures.

In one embodiment, the first and the second film of carbon nanostructures is a free-standing film of carbon nanostructures or a mesh-supported film of carbon nanostructures.

The term "mesh" may in this specification refer to an interlaced structure. A mesh may be taken as a support made of interlaced strands of e.g. metal.

Carbon nanostructures are used to form the first and the second film. The expression "nanostructures" should be understood in this specification, unless otherwise stated, as structures with one or more characteristic dimensions in nanometer scale, i.e. typically ranging from 1 to 100 nm. The dimensions of the nanostructures, in two perpendicular directions, may be in significantly different magnitudes of order. For example, a nanostructure may have a length which is ten, hundred, thousand, or even hundred thousand, times higher than its thickness or width. In a film of carbon nanostructures, a great number of said carbon nanostructures may be interconnected with each other to form a network of interconnected molecules when the carbon nanotubes are collected to a filter. The carbon nanostructures may also retain an aligned or semi-aligned configuration, where individual nanostructures are vertically oriented when the carbon nanotubes are harvested from a carbon nanotube forest. The carbon nanotube forest is a dense, vertically aligned array of carbon nanotubes. These structures may be grown on a substrate using techniques like chemical vapor deposition. When processed into a film, these structures may exhibit partial interconnections due to van der Waals forces or physical entanglement, forming a network while preserving some of the alignment characteristic of the original forest. As considered at a macroscopic scale, such a network forms a solid, monolithic material in which the individual molecular structures are disoriented or non-oriented, i.e. are oriented substantially randomly, or oriented. Various types of carbon nanostructure networks can be produced in the form of thin transparent layers.

In one embodiment, the carbon nanostructures are carbon nanotubes (CNT), carbon nanobuds (CNB), carbon nanoribbons, carbon nanofibers, or any combination or mixture thereof. In one embodiment, the carbon nanostructures are carbon nanotubes, carbon nanobuds, or a combination or mixture of these. The carbon nanobuds, or the carbon nanobud molecules as they also may be called, have fullerene or fullerene-like molecules covalently bonded to the side of a tubular carbon molecule. Carbon nanotubes and carbon nanobuds as such have the added utility of being highly transparent in the X-ray and visible light wavelengths. In addition, they have robust mechanical properties and high chemical inertness.

Various procedures exist in the art that may be used for forming the first and second film of carbon nanostructures. Different methods may be used to synthesize the carbon nanostructures and/or to deposit the same to form a film. In the case of e.g. carbon nanotubes or carbon nanobud molecules, deposition may be carried out, for example, by using the commonly known methods of filtration from gas phase or from liquid, extracting from a solution, deposition in a force field, harvesting from a carbon nanotube forest, or deposition from a solution using spray coating or spin drying. The carbon nanobud molecules can be synthesized, for example, using the method disclosed in WO 2007/057501, and deposited on a substrate, for example, directly from the aerosol flow, e.g. by assistance of e.g. electrophoresis or thermophoresis, or by a method described in Nasibulin et al: "Multifunctional Free-Standing Single-Walled 20 Carbon Nanotube Films", ACS NANO, vol. 5, no. 4, 3214-3221, 2011. Functionalization of carbon nanostructures may be considered as the generation of functional groups on the surfaces of the carbon nanostructures. Functionalization of carbon nanostructures may be done either by physisorption or by covalent attachments. Functionalization of the carbon nanostructures has the added utility of making them more reactive, increasing their solubility, or allowing various chemical modifications, such as ion adsorption, metal deposition, or grafting reactions.

The first and/or second film of carbon nanostructures may be formed by synthesizing carbon nanostructures e.g. in a gas phase from where they are collected or deposited. The carbon nanostructures may be collected or deposited to form a film with no specific orientation, or they may be aligned in a particular direction.

The first film and/or the second film of carbon nanostructures may have the area size of 0.1 - 1000 cm², or 1 - 500 cm², or 5 - 350 cm², or 10 - 200 cm², or 50 - 150 cm².

The thickness of the first and/or the second film of carbon nanostructures may be 1 - 8000 nm, or 5 - 7500 nm, or 15 - 7000 nm, or 20 - 5000 nm, or 50 - 2500 nm, or 100 - 1000 nm, or 200 - 600 nm. In one embodiment, the thickness of the first and the second film of carbon nanostructures is 1 - 600 nm, or 15 - 500 nm, or 20 - 400 nm, or 50 - 300 nm, or 100 - 200 nm, or 75 - 100 nm. In one embodiment, the thickness of the first and the second film of carbon nanostructures is 100 - 8000 nm, or 200 - 7000 nm, or 300 - 5000 nm, or 400 - 2500 nm, or 500 - 1000 nm. The thickness of first and the second film of carbon nanostructures may be measured with a contact profilometer, such as atomic force microscopy (AFM), an optical profilometer, or an ellipsometry, cross-sectional electron microscopy. Forming the first and the second film of carbon nanostructures has the added utility of one being able to form a thin film. However, the first and second film of carbon nanostructures may not be too thin, as this would affect their ability to support themselves when forming a free-standing film. In contrast, when the film is supported by a mesh, the thickness of the first and second films may vary more freely.

The first and the second film of carbon nanostructures may be a free-standing film of carbon nanostructures or a mesh-supported film of carbon nanostructures. The free-standing film may be one that can exist on its own without the need for a supporting substrate. The free-standing film of carbon nanostructures can be self-supporting, meaning that the film has sufficient mechanical integrity and strength to maintain its structure independently. A free-standing film may typically be directly formed as an independent entity but also a substrate-grown film may be produced so as to be free-standing after the substrate is removed. A defining characteristic of any free-standing film can be its ability to maintain its structure without a supporting substrate. Regardless of whether the free-standing film is formed on a substrate or not, it can be considered free-standing if, after any processing steps, it can exist and function independently, in particular as described above. The free-standing film does not need to be directly supported throughout its whole area since it can maintain its structure without a direct support. It provides, by itself, an intrinsic structural support for maintaining its structure, e.g. its shape. This can be observed under gravity, in absence of supporting forces to the free-standing film. The free-standing film(s) as described herein can thus also be understood as self-supporting film(s).

The first and/or the second film of carbon nanostructures may be attached to a support. The support may be any type of support suitable to be attached with the free-standing film of carbon nanostructures. The support may be formed of glass, metal, plastic, or any combination thereof. The form of the support may vary. The support may have the form of a frame. In one embodiment, the support has the form of a frame, and the film or carbon nanostructures is attached to the frame. The frame may support the free-standing film of carbon nanostructures at the outer edges thereof such that an unsupported standalone region of the carbon nanostructure film is formed. The support positions may be located anywhere in the structure as long as they provide sufficient support for the carbon nanostructure film. For example, they may be on the sides of the free-standing film of carbon nanostructures, or in areas near corners, or next to each other along the sides. Any wider area that includes a plurality of support points is also meant to be covered by this aspect, for example if the frame has an uninterrupted circular shape wherein the free-standing region lies within the circle. The frame may also have any other prolonged uninterrupted shape. In one embodiment, the frame is shaped as a circle, a square, a triangle, a rectangle, an oval, or a polygon.

A polymer-based material is formed on the film of carbon nanostructures to form a planarization layer. The term "polymer-based material" as used herein may be taken to refer to a material having a polymer content of 50 - 100 weight-%. As examples of the polymer-based material used to form the planarization layer may be mentioned the following: organic polymers such as parylene and polyamide; naphthalene-containing polymers, oxygen-containing polymers such as poly(methyl methacrylate) (PMMA); hydrocarbon-based polymers consisting of carbon and hydrogen such as polystyrene; oligomers such as short-chain polystyrene, and oligoethylene glycol; solvent processable fluoropolymers such as polyvinylidene floride (PVDF) and polyolefins such as polypropylene, polyethylene, and polymethylpentene.

The polymer-based material may be formed on the first film of carbon nanostructures by a solution-based deposition technique. A solution-based deposition technique may be any generic method where a solution of the coating material is applied by brushing, spraying, immersing, spreading, or dripping onto the film.

In one embodiment, the solution-based deposition technique is selected from spin casting, layer by layer deposition, spray coating, electrophoretic deposition, Langmuir-Blodgett deposition, curtain coating, slot-die coating or dip coating. These techniques are particularly advantageous for coating delicate, free-standing CNT films, as they typically exert lower mechanical stress compared to vacuum-based methods.

Using the solution-based deposition technique for forming the planarization layer has the added utility of being a technique by which one may accurately control the thickness of the formed layer such that a layer thickness down to few tens of nanometers may be formed. Using the solution-based deposition technique has the added utility that one may efficiently fill any gaps present between the carbon nanostructures in the film without the need to form a thick layer. In one embodiment, the solution-based deposition technique is dip coating. Using dip coating for forming the planarization layer has the added utility of producing smooth, uniform, and defect-free coatings, which are beneficial for optical applications. Further, the simplicity of the setup and minimal equipment requirements make dip coating a cost-effective technique.

In one embodiment, the method comprises forming a planarization layer having a thickness of 1 - 200 nm, or 5 - 180 nm, or 10 - 150 nm, or 20 - 100 nm, or 30 - 80 nm, or 40 - 60 nm. The thickness of the planarization layer may be measured by using e.g. electron microscopy cross-section or X-ray reflectivity.

The planarization layer has the added utility of providing a smooth and uniform surface prior to forming a metal-containing or metalloid-containing coating layer thereon. Any unevenness in the surface at this stage would be copied to the metal-containing or metalloid-containing coating layer in an adverse manner, thus affecting the final use of the structure.

Having formed the planarization layer, the metal-containing or metalloid-containing material is formed thereon by a vapor phase deposition technique to form a planarized metal-containing or metalloid-containing coating layer. The term "metal-containing material" as used herein may be taken to refer to a material containing metal element(s) or metal-containing compound(s). In one embodiment, the metal-containing material has a metal content of 50 - 100 weight-%. In one embodiment, the metalloid-containing material has a metalloid content of 50 - 100 weight-%. Thus, the planarized metal-containing or metalloid-containing coating layer may contain metal or metalloid in a total amount of 50 - 100 weight-%. In one embodiment, the vapor phase deposition technique is selected from sputtering deposition, electron-beam physical vapor deposition, thermal evaporation deposition, cathodic arc deposition, pulsed laser deposition or ion beam-assisted deposition. Sputtering deposition uses a plasma to eject material from a target, which then deposits onto the planarization layer. Electron-beam physical vapor deposition utilizes a high-speed electron beam to vaporize the coating material, which then condenses on the planarization lay-er. In thermal evaporation deposition material is heated to a high vapor pressure using electrical resistance, allowing it to deposit on the planarization layer. In cathodic arc deposition a high-power electric arc is utilized to vaporize the target material, which then de-posits onto the planarization layer. In pulsed laser deposition a high-power laser is utilized to ablate material from the target, creating a vapor that deposits on the planarization layer. Ion beam-assisted deposition combines physical vapor deposition with simultaneous ion bombardment to improve film properties.

Using the vapor phase deposition technique for forming the metal-containing or metalloid-containing coating layer has the added utility of one being able to form a thin coating layer with a smooth and uniform surface. The vapor phase technique has the added utility of providing precise, nanometer-scale control over coating thickness, which is beneficial for EUV pellicles.

In one embodiment, the metal-containing or metalloid-containing coating layer has a thickness of 1 - 1000 nm, 1 - 800 nm, or 1 - 500 nm or 1 - 300 nm, or 3 - 100 nm, or 5 - 50 nm, or 7 - 30 nm, or 9 - 20 nm, or 10 - 15 nm. The thickness of the metal-containing or metalloid-containing coating layer may be measured with e.g. transmission electron microscopy (TEM) technique, scanning electron microscopy (SEM) technique, or any other relevant technique.

In one embodiment, the metal-containing material is a material based on aluminum, zirconium, tungsten, niobium, titanium, yttrium, molybdenum, hafnium, vanadium, chromium, tantalum, scandium, gold, palladium, or lanthanum.

In one embodiment, the metalloid-containing material is a material based on boron or silicon.

The metal-containing or metalloid-containing coating layer may contain aluminum, zirconium, tungsten, niobium, titanium, yttrium, hafnium, vanadium, chromium, tantalum, scandium, gold, palladium, lanthanum, iron, nickel, cobalt, manganese , boron or molybdenum, or silicon, or any a carbide, an oxide, a nitride, a sulphide, or boride thereof, or any combination or mixture thereof. The metal-containing or metalloid-containing coating layer may comprise or consist of aluminum, zirconium, tungsten, niobium, silicon, titanium, yttrium, hafnium, vanadium, chromium, tantalum, scandium, gold, palladium, lanthanum, on, nickel, cobalt, manganese, boron or molybdenum, or any a carbide, an oxide, a nitride, a sulphide, or boride thereof, or any combination or mixture thereof. Having formed the planarized metal-containing or metalloid-containing coating layer, the second film of carbon nanostructures is formed thereon.

Having formed the pre-structure, the same is subjected to a densification treatment. In one embodiment, the densification treatment is a vapor phase densification, a thermal annealing, an electrostatic compression or a liquid dipping densification. The densification treatment has the added utility of enhancing the mechanical strength, electrical conductivity, optical properties, and overall uniformity of carbon nanostructure films. In one embodiment, the vapor phase densification is a chemical vapor infiltration. In one embodiment, the liquid dipping densification is a solvent-assisted densification. The liquid dipping densification has the added utility of eliminating the need for vacuum conditions and mechanical pressure, thereby providing a gentler and milder treatment.

In one embodiment, the vapor phase densification treatment is carried out with a solvent in vapor phase at a temperature of 55 - 250 °C, or 55 - 150 °C , or 55 - 100 °C 55 - 75 °C, or 60 - 70 °C, for 15 - 120 seconds, or 20 - 90 seconds, or 30 - 60 seconds. The solvent in vapor phase may be isopropyl alcohol. The vapor phase densification treatment may be conducted by using a solvent in vapor phase, i.e. a vaporized solvent. The formed pre-structure may be placed in a chamber where to a solvent vapor is introduced. This solvent vapor may then condense onto the pre-structure, forming a liquid thin solvent film. The drying effect and surface tension of the solvent film may then pull the structure of the pre-structure together to form a denser and mechanically stronger structure. Densification of the pre-structure has the added utility of coupling or bonding the film of carbon nanostructures and the metal-containing or metalloid-containing coating layer such that they are adhered to each other. The adhesion is remained even in harsh conditions.

After the densification treatment, the planarization layer is removed from the pre-structure by a dissolution technique to produce the planarized structure. The planarization layer serves as a sacrificial layer, as it is removed to produce the planarized structure. In one embodiment, the dissolution technique is selected from wet chemical etching, dry etching, thermal decomposition, supercritical co₂ removal, electrochemical dissolution, solvent-based swelling and dissolution or vapor phase etching. The dissolution technique has the added utility of one being capable to remove the planarization layer from the pre-structure without attacking the metal-containing or metalloid-containing coating layer or the film of carbon nanostructures. Wet chemical etching utilizes a liquid solvent or etchant to chemically react with the sacrificial layer, dissolving it selectively. Dry etching uses reactive gases (plasma) to etch the sacrificial layer without using liquid solvents. Thermal decomposition uses elevated temperatures to decompose the sacrificial layer. Supercritical CO₂ removal utilizes supercritical carbon dioxide (CO₂) as a solvent to remove the sacrificial layer in a controlled process. Electrochemical dissolution utilizes a voltage in an appropriate electrolyte to etch the layer. Solvent-based swelling and dissolution uses solvents to swell and dissolve the material. Vapor phase etching uses reactive vapor-phase chemicals to selectively remove the sacrificial layer.

An increase in exposed surface area may lead to higher oxidation, resulting in a loss of extreme ultraviolet transmittance percentage. Therefore, a planarized structure with less exposed area has the added utility of minimizing oxidation, resulting in a higher extreme ultraviolet transmittance percentage. With less exposed area, there are also fewer pores, voids, or rough regions where dust or foreign particles may accumulate. This not only reduces the potential for contamination but also helps maintain the cleanliness and performance of the optical film over time. This is especially important for optical films used in high-precision applications, as even small amounts of contamination can degrade performance. Therefore, a smoother, less exposed surface makes it harder for contaminants to interact with the material, resulting in improved long-term stability and durability.

### EXAMPLES

Reference will now be made in detail to the described embodiments, an example of which is illustrated in the accompanying drawing.

The description below discloses some embodiments in such a detail that a person skilled in the art is able to utilize the method based on the disclosure. Not all steps of the embodiments are discussed in detail, as some of the steps may be obvious for the person skilled in the art based on this specification.

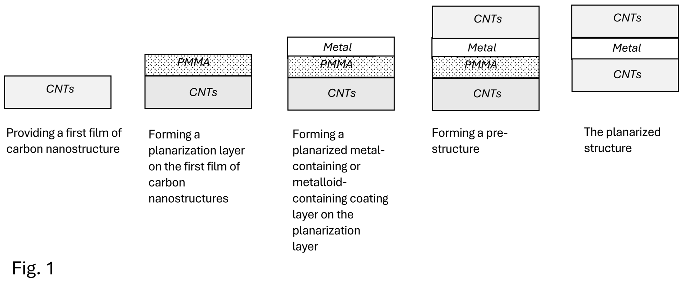

Fig. 1 present one embodiment for producing the planarized structure as disclosed in the current specification.

Firstly, is provided a first film of carbon nanostructures. The first film of carbon nanostructures may be formed by e.g. a gas phase process, wherein carbon nanostructures, such as carbon nanotubes (marked as CNTs in Fig. 1), are synthesized in a gas phase and then deposited or collected on a substrate, such as a porous filter. From the substrate the formed film of carbon nanostructures can be detached and transferred to e.g. a support, such as a frame.

Then, a polymer-based material (marked as PMMA in Fig. 1) is formed on the first film of carbon nanostructures (CNTs) by a solution-based deposition technique to form a planarization layer on the first film of carbon nanostructures.

Then, a metal-containing or metalloid-containing material (marked as metal in Fig. 1) is formed on the planarization layer (PMMA) by a vapor phase deposition technique to form a planarized metal-containing or metalloid-containing coating layer on the planarization layer.

Then, a second film of carbon nanostructures (marked as CNTs) is provided on the planarized metal-containing or metalloid-containing coating layer (metal) to form a pre-structure.

These steps are followed by subjecting the formed pre-structure to a densification treatment, after which the planarization layer is removed from the pre-structure by a dissolution technique to produce the planarized structure. The planarized structure thus is formed of the metal-containing or metalloid-containing coating layer between the first and second film of carbon nanostructures.

### Example 1 - Producing a planarized structure

In this example a planarized structures was produced. The materials used are presented in Table 1.

**Table 1. Materials used for producing the planarized structures**

| | Material |
|---|---|
| Porous collection filter | Mixed cellulose ester |
| Support | Circular frame of steel* |
| Carbon nanostructures | Carbon nanotubes |
| Planarization layer | PMMA |
| Metal-containing or metalloid-containing coating layer | Au/Pd alloy |

| | |
|---|---|
| *A circular frame, 21 mm inner diameter, 37 mm outer diameter | |

Firstly, carbon nanotubes were synthesized in an aerosol laminar flow (floating catalyst) reactor using carbon monoxide and ferrocene as a carbon source and a catalyst precursor, respectively. The formed carbon nanotubes were deposited from the gas phase onto a porous collection filter at a total gas flow rate of 60 l/min (gas velocity of max 0.13 m/s) to form a film of carbon nanotubes on the porous collection filter. The temperature of the gas was about 60 °C. The thickness of the formed first film of carbon nanotubes was 50 nm, which corresponds to 81%T at 550 nm wavelength.

The formed first film of carbon nanotubes was then transferred from the porous collection filter to a rectangular plastic frame that was larger than the final circular frame. Then the same was transferred to the final circular-shaped frame to form a free-standing film of carbon nanotubes attached to the frame. The frame thus had a circular form with an opening in the middle.

Thereafter a polymer-based material was deposited on the first film of carbon nanotubes by dip coating, wherein the dip coating immersion and withdrawal speed was 25 mm/min. Following the coating, the film was subjected to drying in a ventilated oven at 100°C for 15 minutes. In this example PMMA was used as the polymer-based material.

Then a metal-containing coating layer of Au/Pd alloy was formed on the planarization layer with physical vapor deposition technique, in this case sputtering deposition using Ar-plasma (base pressure 1E-5 mbar, operating pressure 1E-2 mbar, deposition rate of about 10 nm/min, non-heated samples, the sputtering target was precleaned for 1 min prior to deposition to remove native oxide) The thickness of the metal-containing coating layer was 50 nm.

Upon the metal-containing coating layer was then formed a film of carbon nanotubes produced as above described.

The formed pre-structure was then subjected to vapor phase densification treatment by placing the pre-structure into a chamber into which an isopropanol vapor was introduced at a temperature of 66 °C for 60 seconds.

After the vapor phase densification treatment a dissolution technique was used to remove the planarization layer from the pre-structure. The film was then dipped in an acetone solvent at 50°C for 1 hour, using the same immersion and withdrawal parameters as those employed for the PMMA deposition.

### Example 2 - Producing a planarized structure

In this example a planarized structure was produced and tested. The materials used are presented in Table 2.

**Table 2. Materials used for producing the planarized structures**

| | Material |
|---|---|
| Porous collection filter | Mixed cellulose ester |
| Support | Mesh |
| Carbon nanostructures | Carbon nanotubes |
| Planarization layer | PMMA |
| Metal-containing or metalloid-containing coating layer | Zr |

Firstly, carbon nanotubes were synthesized in an aerosol laminar flow (floating catalyst) reactor using carbon monoxide and ferrocene as a carbon source and a catalyst precursor, respectively. The formed carbon nanotubes were deposited from the gas phase onto a porous collection filter at a total gas flow rate of 60 l/min (gas velocity of max 0.13 m/s) to form a film of carbon nanotubes on the porous collection filter. The temperature of the gas was about 60 °C. The thickness of the formed first film of carbon nanotubes was 50 nm, which corresponds to 81%T at 550 nm wavelength.

The formed first film of carbon nanotubes was then transferred from the porous collection filter to a rectangular plastic frame that was larger than the final circular frame. Then the same was transferred to the final circular-shaped frame to form a free-standing film of carbon nanotubes attached to the frame. The frame thus had a circular form with an opening in the middle.

Thereafter a polymer-based material was deposited on the first film of carbon nanotubes by dip coating, wherein the dip coating immersion and withdrawal speed was 25 mm/min. Following the coating, the film was subjected to drying in a ventilated oven at 100°C for 15 minutes. In this example PMMA was used as the polymer-based material.

Then a metal-containing coating layer of Zr was formed on the planarization layer with physical vapor deposition technique, in this case sputtering deposition using Ar-plasma (base pressure 1E-5 mbar, operating pressure 5,3E-3 mbar, deposition rate of about 1,83 Å/sec (11 nm/min), non-heated samples, the sputtering target was precleaned for 1 min prior to deposition to remove native oxide) The thickness of the metal-containing coating layer was 50 nm.

Upon the metal-containing coating layer was then formed a film of carbon nanotubes produced as above described.

The formed pre-structure was then subjected to vapor phase densification treatment by placing the pre-structure into a chamber into which an isopropanol vapor was introduced at a temperature of 66 °C for 60 seconds.

After the vapor phase densification treatment a dissolution technique was used to remove the planarization layer from the pre-structure. The film was then dipped in an acetone solvent at 50°C for 1 hour, using the same immersion and withdrawal parameters as those employed for the PMMA deposition.

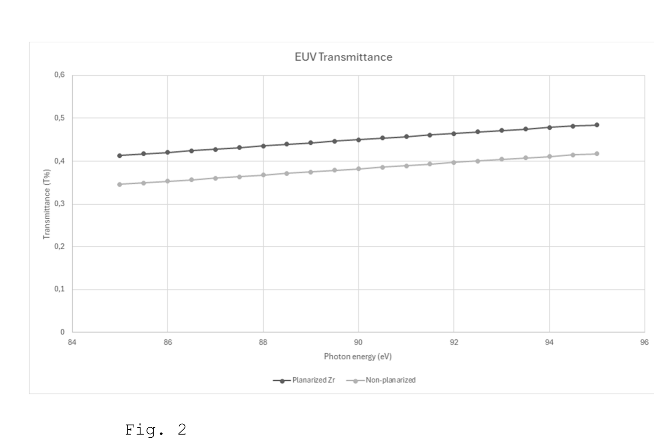

The formed planarized structure was subjected EUV measurement by using a particle accelerator (synchrotron). The results are presented in Fig. 2.

### Example 3 - Testing planarized structures

In this example the planarized structure produced following the description in example 2 was tested and compared to samples, wherein a metal-containing coating layer was directly formed on a film of carbon nanotubes without using the planarization layer.

The formed samples were subjected EUV measurements by using a particle accelerator (synchrotron). The results are presented in Fig. 2.

The results indicated that when producing a planarized structure, i.e. when using a planarization layer of a polymer-based material on which the Zr-containing coating layer is formed, the visible transmittance was about 7.5 %, whereas forming the same material directly on a film of carbon nanostructures without using a planarization layer of a polymer-based material, the visible transmittance was about 14.8 %.

It was concluded that the difference in the visible transmittance was due to pinholes in the porous film of carbon nanotubes, contrary to the situation where the Zr-containing coating layer was formed on a planarization layer, which makes the surface continuous and ideally pinhole-free.

Further, it was also concluded that when forming the Zr-containing coating layer directly on the porous film of carbon nanotubes, oxidation takes place due to the disordered morphology which translates into increased chemical reactivity.

It is obvious to a person skilled in the art that with the advancement of technology, the basic idea may be implemented in various ways. The embodiments are thus not limited to the examples described above; instead they may vary within the scope of the claims.

The embodiments described hereinbefore may be used in any combination with each other. Several of the embodiments may be combined together to form a further embodiment. A method, a structure, or a use, as disclosed herein, may comprise at least one of the embodiments described hereinbefore. It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item refers to one or more of those items. The term "comprising" is used in this specification to mean including the feature(s) or act(s) followed thereafter, without excluding the presence of one or more additional features or acts.

## Claims

1. A method for producing a planarized structure consisting of a metal-containing or metalloid-containing coating layer between a first and a second film of carbon nanostructures, wherein the method comprises:
- providing a first film of carbon nanostructures,
- forming a polymer-based material on the first film of carbon nanostructures by a solution-based deposition technique to form a planarization layer on the first film of carbon nanostructures,
- forming a metal-containing or metalloid-containing material on the planarization layer by a vapor phase deposition technique to form a planarized metal-containing or metalloid-containing coating layer on the planarization layer,
- providing a second film of carbon nanostructures on the planarized metal-containing or metalloid-containing coating layer to form a pre-structure,
- subjecting the formed pre-structure to a densification treatment; and
- removing the planarization layer from the pre-structure by a dissolution technique to produce the planarized structure.

2. The method of claim 1, wherein the first and the second film of carbon nanostructures is a free-standing film of carbon nanostructures or a mesh-supported film of carbon nanostructures.

3. The method of any one of the preceding claims, wherein the polymer-based material is polymethyl methacrylate.

4. The method of any one of the preceding claims, wherein the metal-containing material is a material based on aluminum, zirconium, tungsten, niobium, titanium, yttrium, molybdenum, hafnium, vanadium, chromium, tantalum, scandium, gold, palladium, lanthanum, iron, nickel, cobalt, or manganese.

5. The method of any one of the preceding claims, wherein the metalloid-containing material is a material based on silicon or boron.

6. The method of any one of the preceding claims, wherein the method comprises forming a metal-containing or metalloid-containing coating layer having a thickness of 1 - 1000 nm, 1 - 800 nm, or 1 - 500 nm, or 1 - 300 nm, or 3 - 100 nm, or 5 - 50 nm, or 7 - 30 nm, or 9 - 20 nm, or 10 - 15 nm.

7. The method of any one of the preceding claims, wherein the solution-based deposition technique is selected from spin casting, layer by layer deposition, spray coating, electrophoretic deposition, Langmuir-Blodgett deposition, curtain coating, slot-die coating or dip coating.

8. The method of any one of the preceding claims, wherein the vapor phase deposition technique is selected from sputtering deposition, electron-beam physical vapor deposition, thermal evaporation deposition, cathodic arc deposition, pulsed laser deposition or ion beam-assisted deposition.

9. The method of any one of the preceding claims, wherein the densification treatment is a vapor phase densification, a thermal annealing, an electrostatic compression or a liquid dipping densification.

10. The method of any one of the preceding claims, wherein the dissolution technique is selected from wet chemical etching, dry etching, thermal decomposition, supercritical co₂ removal, electrochemical dissolution, solvent-based swelling and dissolution, or vapor phase etching.

11. Use of a planarized structure obtainable by the method of any one of claims 1 - 10, as an optical filter, an optical mirror, a debris filter, a pellicle, a membrane filter, an electron blocking window, an X-ray window, an X-ray optical filter and an X-ray optical filter mirroror any combination of at least two of these.

12. The use of claim 11, wherein the planarized structure is used as an extreme ultraviolet lithography pellicle.
